# FASCICULE DE BREVET EUROPEEN

(11) **EP 0 370 924 B1**
(45) Date de publication et mention de la délivrance du brevet: **16.03.1994**
(21) Numéro de dépôt: 89420453.6
(22) Date de dépôt: 20.11.1989
(51) Int. Cl.: H03K 21/12

(54) **Compteur d'impulsions d'horloge à fréquence élevée**
Hochfrequenz-Taktimpulszähler
High frequency clock pulse counter

(30) Priorité: 23.11.1988 FR 8815998
(43) Date de publication de la demande: 30.05.1990
(73) Titulaire: SEXTANT AVIONIQUE S.A., F-92366 Meudon la Forêt Cédex (FR)
(72) Inventeur: Payen, Hubert, F-26000 Valence (FR); Pain, Bernard, F-26000 Valence (FR)
(74) Mandataire: de Beaumont, Michel

(56) Documents cités:
- EP-A- 0 133 735
- US-A- 3 982 108
- ELECTRONIC DESIGN, vol. 15, no. 11, 24 mai 1967, page 107, Rochelle Park, US; "Simple logic reads out during counting"

## Description

La présente invention concerne un compteur d'impulsions d'horloge et plus particulièrement un tel compteur destiné à fonctionner à très haute fréquence.

Ce compteur pourra par exemple être réalisé à partir d'un circuit intégré à cellules prédiffusées ou précaractérisées.

Classiquement, pour réaliser un compteur d'impulsions d'horloge, on associe un grand nombre de cellules de comptage de bits, elles-mêmes regroupées par blocs.

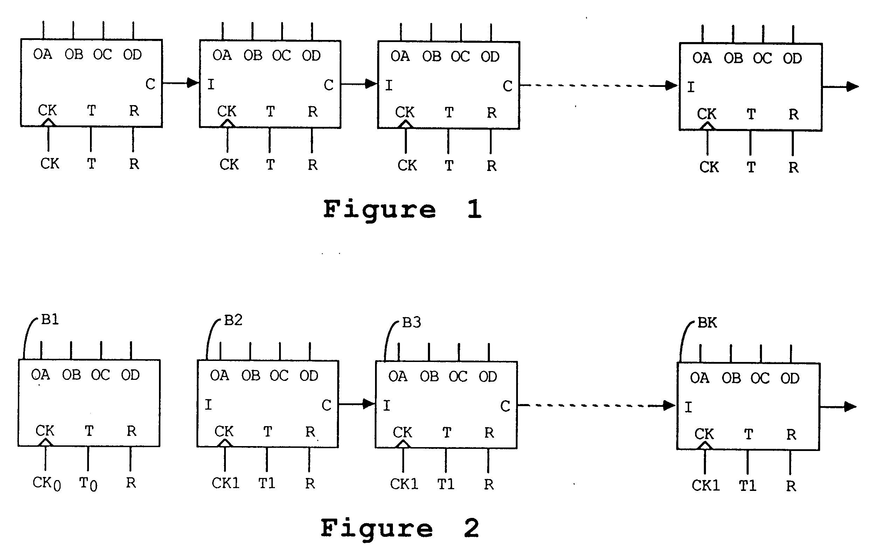

La figure 1 représente de façon très schématique un tel assemblage dans lequel chaque bloc comprend quatre sorties de comptage OA, OB, OC et OD. Tous les blocs comprennent une entrée d'horloge CK recevant le même signal en impulsions à compter, CK, une entrée de remise à zéro R recevant le même signal de remise à zéro, R, et une entrée de transfert T recevant un même signal d'ordre de transfert, T. Chaque bloc transmet à l'entrée I du suivant un signal de retenue par une borne C quand tous ses bits sont à un. Chaque bloc comprend des bascules de comptage proprement dites et des bascules de mémorisation dans lesquelles le contenu de toutes les bascules de comptage est transféré au moment où un ordre de transfert T est appliqué aux entrées T. Cet ordre T est resynchronisé sur le signal d'horloge CK de façon à mémoriser une information stable de l'état des sorties de comptage OA, OB, OC, OD.

Cette architecture classique présente l'inconvénient que, quand on veut compter des impulsions d'horloge se répétant à un rythme très rapide, tous les blocs, qui sont identiques, doivent être réalisés aux limites de la technologie de fabrication. Il en résulte que toutes bascules sont réalisées selon des règles de dessin critiques et que la consommation du circuit peut être importante. En conséquence, le rendement de fabrication de tels compteurs, fabriqués par exemple à partir de réseaux de portes prédiffusés, est faible.

Pour remédier à cet inconvénient, le document EP-A-0 133 735 propose de diviser le compteur en un bloc de comptage des bits de rang inférieur à haute précision et en des blocs de comptage des bits de rang supérieur fonctionnant à une fréquence plus lente et donc moins critiques à réaliser. Ce document propose aussi des moyens pour éviter des problèmes liés à l'instant d'arrivée d'un ordre de transfert (ou de lecture) du contenu du compteur, mais ces moyens sont des moyens analogiques et leurs efficacité dépend des fluctuations de fabrication du circuit.

Plus particulièrement, la présente invention prévoit un mode d'application de signaux d'horloge et de signal de transfert aux cellules de rang supérieur à partir des signaux d'horloge et de transfert appliqués aux cellules de rang inférieur permettant d'éviter toute ambiguïté au moment de la lecture du compteur (moment d'application de l'ordre de transfert).

Ainsi, la présente invention prévoit un compteur à n cellules de un bit recevant un signal d'horloge de fréquence f à compter et un ordre de transfert au moment où l'on souhaite lire le compteur, dans lequel les p cellules d'ordre inférieur sont adaptées à fonctionner à la fréquence f et les n-p cellules d'ordre supérieur à la fréquence f/2^{p}. Les p cellules d'ordre inférieur reçoivent directement de signal d'horloge à la fréquence f et, quand il y a lieu, un ordre de transfert synchronisé sur le signal d'horloge. Les n-p cellules d'ordre supérieur reçoivent, comme signal d'horloge à la fréquence f/2^{p}, un signal retardé au moins de deux impulsions d'horloge et au plus de p impulsions d'horloge par rapport au signal de sortie de la cellule de poids le plus élevé parmi les p cellules d'ordre inférieur, et, comme signal de transfert, une impulsion retardée par rapport audit ordre de transfert de façon à survenir seulement lors de l'impulsion d'horloge suivante ou en cours qui correspond à une mise à un de toutes les cellules des p premières cellules.

Grâce à cette organisation, la demanderesse a pu réaliser un compteur à 24 bits dont seules trois cellules correspondant aux trois bits d'ordre inférieur fonctionnent à la fréquence d'horloge maximum, par exemple de l'ordre de 30 MHz, les autres cellules fonctionnant à un rythme huit fois moins rapide et n'étant donc pas critiques.

Ces objets, caractéristiques et avantages ainsi que d'autres de la présente invention seront exposés plus en détail dans la description suivante d'un mode de réalisation particulier de la présente invention faite en relation avec les figures jointes parmi lesquelles :
la figure 1 représente sous forme de blocs la conception d'ensemble d'un compteur numérique selon l'art antérieur ;
la figure 2 représente sous forme de blocs la conception d'ensemble d'un compteur selon la présente invention ;
la figure 3 représente un exemple d'un bloc de comptage classique, utilisable pour les cellules de rang supérieur du compteur selon la présente invention ;
la figure 4 représente un circuit comprenant les cellules de rang inférieur d'un compteur selon la présente invention et des moyens pour fournir des signaux d'horloge et de transfert pour les blocs de comptage d'ordre supérieur ; et
la figure 5 représente des chronogrammes de signaux destinés à expliquer le fonctionnement du compteur selon la présente invention.

Comme le représente la figure 2, une particularité du compteur à n bits selon la présente invention est que le bloc de comptage B1 des p bits de rang inférieur est séparé des blocs de comptage B2, B3 ... Bk des n-p bits de rang supérieur. Alors que le bloc de comptage B1 reçoit les signaux d'horloge CK0 à la fréquence que l'on veut effectivement compter sur son entrée CK, les blocs B2, B3 ... Bk reçoivent des signaux d'horloge CK1 à une fréquence divisée par 2^{p} par rapport à la fréquence d'horloge CK0, p étant le nombre de cellules de comptage du bloc B1. Ainsi, il n'y a pas de transmission de retenue entre le bloc B1 et le bloc B2 mais seulement entre le bloc B2 et les blocs suivants.

Une telle architecture présente des avantages en ce que les blocs B2, B3 ... Bk fonctionnant à fréquence plus lente que le bloc B1 peuvent être conçus de façon moins rigoureuse quant à leurs règles de dessin sur un circuit intégré et donc que le rendement d'ensemble sera simplifié puisque seul le bloc B1 doit être réalisé aux limites de la technologie utilisée. En outre, du fait de la plus faible fréquence appliquée aux blocs B2, B3 ... Bk, la consommation de ces blocs, et donc la consommation d'ensemble du compteur est réduite.

Ce circuit présente toutefois des difficultés quant à la lecture du compteur au moment de la fourniture de l'ordre de transfert. En effet, dans un compteur à grand nombre de blocs, les temps de transmission de retenue d'un bloc à l'autre sont loin d'être négligeables devant la fréquence d'horloge et, par exemple sur un compteur de 24 bits et pour une fréquence de comptage élevée, les temps de transmission peuvent être de l'ordre de 2 à 3 impulsions d'horloge.

Ainsi, comme cela a été exposé précédemment, la présente invention prévoit :
- d'une part, de retarder le signal d'horloge CK1 appliqué aux blocs de rang supérieur par rapport au signal de sortie de la dernière cellule du bloc de rang inférieur,
- d'autre part, une fois l'ordre de transfert général reçu, d'appliquer une impulsion de transfert (ou ordre de lecture) aux blocs d'ordre supérieur seulement au voisinage de l'instant où toutes les cellules du bloc de rang inférieur passent à 1. A cet instant le signal CK1 appliqué aux blocs de rang supérieur est inactif ce qui évite toute évolution des blocs B2 à Bk.

Ces caractéristiques de la présente invention seront décrites plus en détail ci-après en relation avec un mode de réalisation plus particulier de celle-ci.

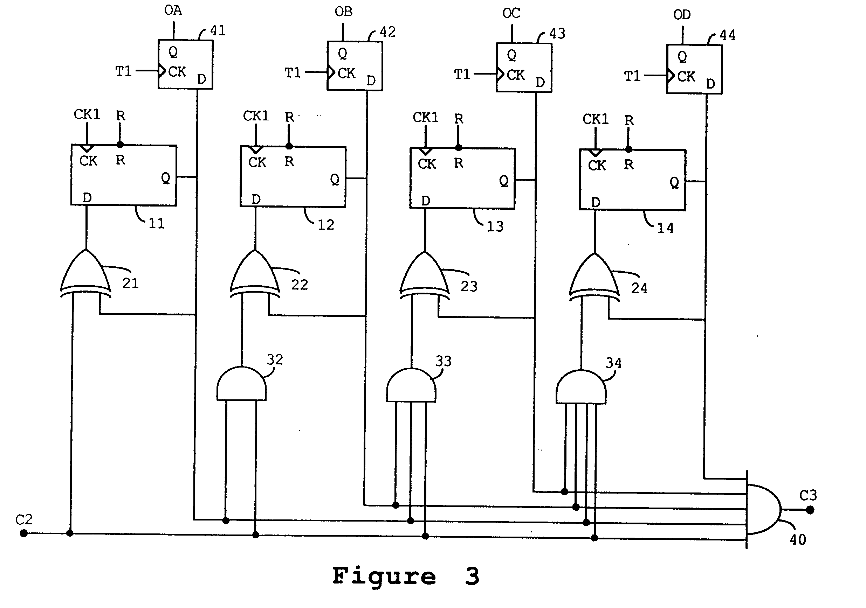

La figure 3 représente un bloc de comptage comprenant quatre cellules correspondant à un bloc intermédiaire parmi les blocs B2, B3 ... Bk illustrés en figure 2, par exemple le bloc B3. Ce bloc de comptage comprend des bascules de type D 11, 12, 13, 14 comprenant chacune une entrée d'horloge CK, une entrée de remise à zéro R, une entrée de basculement D, et une sortie Q. L'entrée D de chaque bascule 11, 12, 13, 14 reçoit la sortie d'une porte OU Exclusif, respectivement 21, 22, 23, 24. La première entrée de chacune des portes OU Exclusif 21, 22, 23, 24 reçoit la sortie Q de la bascule 11, 12, 13, 14 correspondante. La deuxième entrée de chacune de ces portes OU Exclusif reçoit le signal de retenue C2 du bloc précédent, directement en ce qui concerne la première cellule (21) du bloc, et par l'intermédiaire de portes ET 32, 33, 34 en ce qui concerne les cellules suivantes. Les portes ET 32, 33, 34 combinent le signal C2 avec la sortie de la ou des cellules précédentes du même bloc. Toutes les sorties Q des bascules 11, 12, 13, 14 ainsi que le signal de retenue C2 du bloc précédent sont combinés dans une porte ET 40 pour fournir le signal de retenue C3 du bloc considéré.

Enfin, les sorties Q des bascules de comptage 11, 12, 13, 14 sont respectivement fournies aux entrées D de bascules de mémorisation 41, 42, 43, 44 qui sont chargées à l'instant où un signal de transfert T1 est fourni à leur entrée CK pour indiquer sur leur sortie Q l'état de la bascule de comptage correspondante. Ces bascules de mémorisation 41, 42, 43, 44 ont été représentées comme des bascules de type D mais peuvent être d'autres bascules à mémorisation, par exemple celles couramment désignées sous l'appellation d'origine anglo-saxonne latch.

Le fonctionnement d'un tel circuit ne sera pas décrit en détail puisqu'il est connu de l'homme de l'art. On rappellera simplement que le signal de retenue de sortie C3 est fourni seulement quand toutes les bascules du bloc sont à un, immédiatement avant ou après que ces bascules soient remises à zéro.

Le bloc de la figure 3 ne constitue qu'un exemple de réalisation d'un bloc de comptage. De nombreuses variantes ont été imaginées dans la technique pour en optimiser la réalisation et en accélérer éventuellement le fonctionnement. En effet, le temps de transmission à travers une porte n'est pas négligeable et l'on veillera à réaliser des combinaisons optimales pour minimiser le temps de transmission d'ensemble. Par exemple, les cellules ne seront pas nécessairement à quatre blocs, et les diverses portes pourront être réalisées selon des sous-combinaisons si cela semble souhaitable. D'autre part, on rappellera que le bloc illustré en figure 3 était un bloc intermédiaire d'un compteur. S'il s'agissait du premier bloc, il ne recevrait pas de signal de retenue d'un bloc antérieur et la première cellule du bloc (cellule de plus faible poids) aurait par exemple son entrée D couplée à sa sortie Q par un simple inverseur.

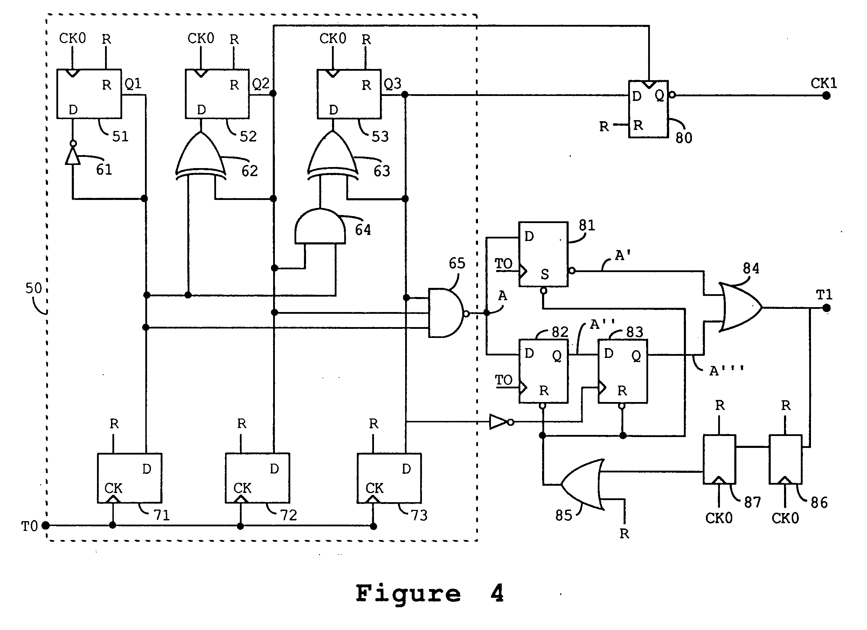

La figure 4 représente la réalisation d'un premier bloc de comptage, correspondant aux bits les moins significatifs d'un compteur selon la présente invention et un circuit destiné à fournir les signaux d'horloge et de transfert des étages de rang plus élevé du compteur (tels celui de la figure 3).

En figure 4, le bloc de comptage et de mémorisation est représenté à l'intérieur du cadre en pointillés désigné par la référence 50. Il reçoit les entrées CK0 de l'horloge à compter, une entrée R de remise à zéro et une entrée T0 de transfert.

Dans l'exemple représenté, le bloc 50 comprend trois bascules de comptage 51, 52, 53 analogues à celles des cellules de la figure 3 sauf que la bascule 51 correspondant au bit de plus faible poids a son entrée D directement reliée à sa sortie par l'intermédiaire d'un inverseur 61 tandis que les entrées D des bascules 52 et 53 sont reliées aux sorties de portes OU Exclusif 62 et 63. La première entrée de la porte OU Exclusif 62 reçoit la sortie Q2 de la bascule 52 et sa deuxième entrée la sortie Q1 de la bascule 51. La première entrée de la porte OU Exclusif 63 reçoit la sortie Q3 de cette bascule et sa deuxième entrée reçoit la sortie d'une porte ET 64 dont les première et deuxième entrées reçoivent respectivement les signaux Q1 et Q2. Les trois sorties Q1, Q2, Q3 sont reliées à trois entrées d'une porte ET 65 à sortie inversée (porte ET NON). En outre, les sorties Q1, Q2, Q3 sont reliées aux entrées D de bascules de mémorisation 71, 72 et 73, respectivement, pour y transférer le contenu des bascules 51, 52, 53 à l'instant où est fournie une impulsion de transfert T0 sur leur entrée d'horloge CK. Cette impulsion de transfert est synchronisé sur le signal d'horloge à compter.

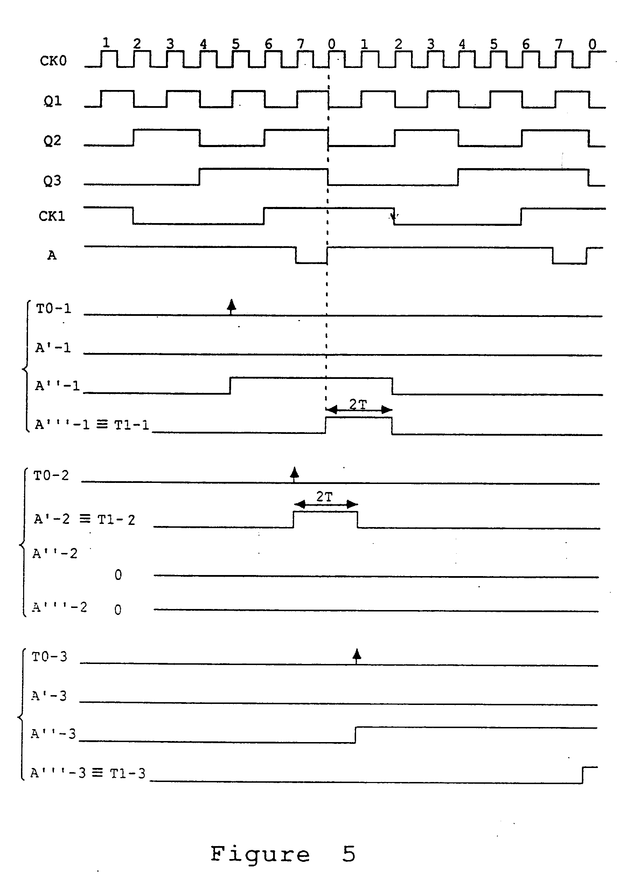

La figure 5 représente l'allure des signaux :
- CK0 d'impulsions d'horloge d'entrée,
- Q1 de sortie de la bascule 51,
- Q2 de sortie de la bascule 52,
- Q3 de sortie de la bascule 53,
- A de sortie de la porte ET 65.

On notera que, comme on utilise une sortie inversée de la porte ET 65, le signal A est à bas niveau quand toutes les entrées de la porte ET, c'est-à-dire le contenu des trois bascules 51, 52, 53, sont à un.

En outre, la présente invention prévoit, comme cela a été exposé précédemment, de commander à un rythme plus faible les blocs de comptage de rang supérieur. Pour cela, la présente invention prévoit non seulement d'envoyer à ces blocs un signal d'horloge CK1 correspondant en fréquence au signal de sortie Q3 de la bascule 53, mais en outre de retarder ce signal CK1 pour éviter toute ambiguïté dans le cas d'un transfert ayant lieu au voisinage du remplissage du premier bloc de comptage des bits de rang inférieur.

Ce signal d'horloge CK1 retardé par rapport au signal d'horloge CK0 et à une fréquence 8 (2³) plus faible peut être fourni, comme cela est représenté, par une bascule de type D 80 dont l'entrée D reçoit la sortie Q3 de la bascule 53 et dont l'entrée d'horloge reçoit la sortie Q2 de la bascule 52 pour fournir sur sa sortie inversée Q* le signal CK1 recherché illustré en figure 5. Ainsi, le signal CK1 correspond au signal Q3 retardé de 3 x 2 impulsions de l'horloge CK0 (ou plus généralement de 3 x 2p⁻²).

D'autre part, à la sortie de la porte ET 65, est disposé le circuit de fourniture du signal de transfert T1 destiné aux blocs d'ordre supérieur. Ce circuit comprend une première bascule de type D 81 et une deuxième bascule de type D 82 recevant toutes deux sur leur entrée D la sortie de la porte ET 65 et sur leur entrée d'horloge l'impulsion de transfert T0 du système. La sortie Q de la deuxième bascule 82 est fournie à l'entrée D d'une troisième bascule 83 dont l'entrée d'horloge reçoit le signal Q3 inversé. La sortie inversée Q* de la bascule 81 et la sortie directe de la bascule 83 sont reliées à deux entrées d'une porte OU 84 dont la sortie fournit le signal T1 recherché. En outre, il est prévu un système pour repositionner les bascules 81, 82, 83. A titre d'exemple, ce circuit de remise à zéro reçoit l'impulsion T1 et la refournit à une porte OU 85 après un retard de deux périodes de l'horloge CK0 au moyen de deux bascules 86 et 87 recevant sur leur entrée d'horloge ce signal CK0. La sortie de la porte OU 85 est envoyée aux entrées de remise à zéro (A) des bascules 82 et 83 et à une entrée de mise à un (S) de la bascule 81. La deuxième entrée de la porte OU 85 reçoit le signal R de remise à zéro de l'ensemble du compteur.

Pour expliquer le fonctionnement du circuit de signal de transfert T1, on désigne par A′ la sortie de la bascule 81, par A'' la sortie de la bascule 82 et par A''' la sortie de la bascule 83.

Les chronogrammes T0-1, A′-1, A''-1 et A'''-1 représentent l'état du circuit de fourniture de l'impulsion de transfert T1 dans le cas où le signal de transfert T0, en ce cas T0-1 arrive avant que le signal A de sortie de la porte ET 65 ait commuté à bas niveau, c'est-à-dire avant que le bloc de comptage comprenant les bascules 51, 52, 53 soit arrivé à son comptage maximum. Avant l'arrivée du signal T0-1, en raison des signaux de remise à zéro indiqués précédemment, les signaux A′, A'' et A''' sont à bas niveau. A l'instant de l'arrivée d'impulsion T0-1, les sorties directes des bascules 81 et 82 passent à haut niveau, c'est-à-dire que le signal A′-1 qui correspond à la sortie inversée reste à bas niveau tandis que le signal A''-1 passe à haut niveau. Ensuite, le signal A'''-1 passe à haut niveau dès que le signal Q2 effectue sa transition suivante de haut à bas niveau (cette bascule reçoit le signal Q2 inversé). Ensuite, le signal A'''-1 reste à haut niveau pendant deux durées du signal d'horloge CK0 (2T) puis repasse à zéro sous l'action du circuit de remise à zéro 85, 86, 87.

A la sortie de la porte OU 84, le signal T1-1 correspondra donc à ce signal A'''-1. De préférence, les bascules de mémorisation associées aux bascules de comptage de rang supérieur seront telles qu'elles mémorisent les informations des bascules de comptage seulement à la fin de l'intervalle 2T illustré, c'est-à-dire à la fin de l'impulsion T1. Ainsi, le retard entre la prise de mesure et le dernier actionnement de ces bascules de comptage sera au minimum de quatre périodes T de la bascule CK0 (deux périodes T liées au fait que le signal CK1 est retardé de six périodes par rapport au signal Q3 plus deux périodes associées à la durée de l'impulsion T1).

Le cas où l'ordre de transfert arrive au moment où les trois bascules de rang inférieur 51, 52, 53 sont à leur comptage maximum est illustré par l'impulsion T0-2. Dans ce cas, il convient de lire les blocs des bascules de rang supérieur avant que la première impulsion de comptage CK1 leur soit fournie.

Dans ce cas, comme le montrent les courbes A''-2 et A'''-2, les bascules 82 et 83 restent à bas niveau et la sortie A′-2 de la bascule 81 passe à haut niveau dès l'arrivée de l'impulsion T0 et c'est ce signal A′-2, remis à zéro après deux périodes d'horloge T, qui est transmis à la sortie de la porte OU 84.

Ainsi, du fait que l'on a prévu un retard de six périodes d'horloge pour l'application du signal CK1 des blocs d'ordre supérieur, on est certain que la lecture de l'indication de ces blocs supérieurs ne tient pas compte du débordement du bloc de rang inférieur (51, 52, 53). En outre, les blocs supérieurs auront eu un temps suffisant pour se stabiliser (trois ou quatre périodes d'horloge T, comme cela a été indiqué ci-dessus).

Enfin, si l'ordre de transfert arrive immédiatement après passage à 1 du bloc de comptage inférieur, comme l'illustre l'impulsion T0-3, on est exactement dans le même cas que dans celui de l'ordre T0-1 et la lecture de l'indication des blocs d'ordre supérieur se fera à la transition haut/bas suivante du signal de transfert T1-3, ce qui laisse un temps de stabilisation d'au moins quatre périodes d'horloge pour ces blocs.

Bien entendu, la présente invention est susceptible de nombreuses variantes. En particulier, on pourra choisir d'autres modes de réalisation des blocs de comptage, aussi bien pour le bloc de rang inférieur que pour les blocs de rang supérieur, que ceux qui ont été illustrés ci-dessus. D'autre part, les divers perfectionnements généralement apportés aux blocs de comptage pourront être également combinés avec la présente invention ; en particulier, dans les structures pratiques on prévoira des entrées de signaux de test et des partitions sélectionnées des diverses portes et bascules. De même il existe de nombreuses variantes pour réaliser les signaux CK1 et T1 nécessaires au bon fonctionnement des blocs de rang supérieur.

## Revendications

1. Compteur à n cellules de un bit recevant un signal d'horloge (CK0) de fréquence f à compter et un ordre de transfert (TO) au moment où l'on souhaite lire le compteur, dans lequel les p cellules d'ordre inférieur sont adaptées à fonctionner à la fréquence f et les n-p cellules d'ordre supérieur à la fréquence f/2^{p}, et dans lequel ces p cellules d'ordre inférieur reçoivent directement le signal d'horloge (CK0) à la fréquence f et, quand il y a lieu, l'ordre de transfert (T0) synchronisé sur le signal d'horloge, caractérisé en ce que les n-p cellules d'ordre supérieur reçoivent :
- comme signal d'horloge à la fréquence f/2^{p}, un signal (CK1) retardé au moins de 2 impulsions d'horloge à la fréquence f et au plus de (2^{p} - 2) impulsions d'horloge à la fréquence f par rapport au signal de sortie (Q3) de la cellule de poids le plus élevé (53) parmi les p cellules d'ordre inférieur (51..53), et
- comme signal de transfert, une impulsion (T1) retardée par rapport audit ordre de transfert (TO) de façon à survenir seulement lors de l'impulsion d'horloge suivante ou en cours qui correspond à une mise à un de toutes les p premières cellules.

2. Compteur selon la revendication 1, caractérisé en ce que le signal d'horloge retardé des n-p cellules d'ordre supérieur est retardé de sensiblement 3 x 2^{p-2} impulsions d'horloge.

3. Compteur selon la revendication 2, caractérisé en ce que le signal retardé est fourni par une bascule de type D (80) dont l'entrée D reçoit la sortie (Q3) de la cellule d'ordre p des p premières cellules et dont l'entrée d'horloge reçoit la sortie (Q2) de la cellule d'ordre p-1.

4. Compteur selon la revendication 1, caractérisé en ce que l'impulsion de transfert (T1) des (n-p) cellules d'ordre supérieur est fournie par un circuit comprenant :
- une porte ET NON (65) dont la sortie est connectée à l'entrée D de première (81) et seconde (82) bascules de type D dont l'entrée d'horloge reçoit ledit ordre de transfert (T0),
- une troisième bascule de type D (83) recevant la sortie directe de la deuxième bascule et dont l'entrée d'horloge reçoit la sortie (Q2) de la p-ième cellule (53) parmi les p premières (51, 52, 53),
- une porte OU (84) dont la première entrée reçoit la sortie inversée de la première bascule de type D (81) et dont la deuxième entrée reçoit la sortie directe de la troisième bascule de type D (83), la sortie de cette porte OU fournissant ladite impulsion de transfert (T1) pour les n-p cellules d'ordre supérieur, et
- un circuit de remise à zéro (85, 86, 87) pour remettre à zéro les deuxième et troisième bascules et pour mettre à un la première bascule peu après la fourniture de ladite impulsion de transfert (T1).

5. Compteur selon l'une quelconque des revendications 1 à 4, caractérisé en ce que p = 3 et n = 24.

6. Compteur selon la revendication 5, caractérisé en ce que la fréquence d'horloge (f) des p premières cellules est de 30 MHz.

## Claims

1. A counter comprising n one-bit cells receiving a clock signal (CK0) having a frequency **f** to be counted and a transfer order (TO) at the time it is desired to read the counter, wherein the p cells of the lower rank are adapted to operate at the frequency **f** and the n-p cells of the higher rank at the frequency f/2^{p}, and wherein the p cells of the lower rank directly receive said clock signal (CK0) at the frequency **f** and, when necessary, said transfer order (T0) synchronized with said clock signal, characterized in that the n-p cells of the higher rank receive:
- as a clock signal at the frequency f/2^{p}, a signal (CK1), delayed by at least two clock pulses at the frequency **f** and at the most by (2^{p} - 2) clock pulses at the frequency **f** with respect to the output signal (Q3) of the cell (53) having the highest rank among the p cells (51...53) of the lower rank, and
- as a transfer signal, a pulse (T1) delayed with respect to said transfer order (TO) so as to occur only during the following or present clock period which corresponds to a setting to "1" of all the first p cells.

2. A counter according to claim 1, characterized in that the delayed clock signal (CK1) of the n-p cells of the higher rank is delayed by substantially 3 x 2^{p-2} clock pulses.

3. A counter according to claim 2, characterized in that the delayed clock signal (CK1) is supplied by a D-type flip-flop (80), the input D of which receives the output (Q3) of the p^{th} cell of the first p cells and the clock input of which receives the output (Q2) of the (p-1)^{th} cell.

4. A counter according to claim 1, characterized in that the transfer pulse (T1) of the (n-p) cells of the higher rank is supplied by a circuit comprising :
an AND-NOT gate (65), the output of which is connected to the input D of the first (81) and second (82) D-type flip-flops, the clock input of which receives said transfer order (TO),
a third D-type flip-flop (83) receiving the direct output of the second flip-flop and the clock input of which receives the output (Q2) of the p^{th} cell (53) among the first p ones (51, 52, 53),
an OR gate (84), the first input of which receives the complementary output of the first D-type flip-flop (81) and the second input of which receives the direct output of the third D-type flip-flop (83), the output of this OR gate supplying said transfer pulse (T1) for the n-p cells of the higher rank, and
a reset circuit (85, 86, 87) for resetting the second and third flip-flops and for setting the first flip-flop to "1" shortly after said transfer pulse (T1) has been supplied.

5. A counter according to any of claims 1 to 4, characterized in that p = 3 and n = 24.

6. A counter according to claim 5, characterized in that the clock frequency (f) of the first p cells is 30 MHz.

## Patentansprüche

1. Zähler mit n-Zellen zu einem Bit, der ein zu zählendes Taktsignal (CKO) der Frequenz f und einen Übertragungsbefehl (TO) in dem Moment empfängt, in dem man den Zähler auszulesen wünscht, bei dem die p Zellen niedrigeren Ranges für einen Betrieb mit der Frequenz f und die n-p Zellen höheren Ranges für einen Betrieb mit der Frequenz f/2^{p} ausgelegt sind und bei dem die p Zellen niedrigeren Ranges direkt das Taktsignal (CKO) mit der Frequenz f und, wenn er auftritt, den Übertragungsbefehl synchronisiert mit dem Taktsignal empfangen, dadurch gekennzeichnet, daß die n-p Zellen höheren Ranges
- als Taktsignal mit der Frequenz f/2^{p} ein Signal (CK1) empfangen, das um mindestens zwei Taktimpulse der Frequenz f und um höchstens (2^{p}-2) Taktimpulse der Frequenz f in bezug auf das Ausgangssignal (Q3) der Zelle mit dem höchsten Rang (53) unter den p Zellen niedrigeren Ranges (51....53) verzögert ist, und
- als Übertragungssignal einen Impuls (T1) empfangen, der in bezug auf den genannten Übertragungsbefehl (TO) derart verzögert ist, daß er nur während des folgenden Taktimpulses oder im Zuge des Setzens aller p ersten Zellen auf Eins auftritt.

2. Zähler nach Anspruch 1, dadurch gekennzeichnet, daß das verzögerte Taktsignal der n-p Zellen höheren Ranges um 3 x 2^{p-2} Taktsignale verzögert ist.

3. Zähler nach Anspruch 2, dadurch gekennzeichnet, daß das verzögerte Signal über eine D-Flip-Flop (80) geliefert wird, dessen D-Eingang das Ausgangssignal (Q3) der Zelle des Ranges p der p ersten Zellen empfängt und dessen Takteingang das Ausgangssignal (Q2) der Zelle des Ranges p-1 empfängt.

4. Zähler nach Anspruch 1, dadurch gekennzeichnet, daß der Übertragungsimpuls (T1) der (n-p) Zellen höheren Ranges durch eine Schaltung geliefert wird, die folgende Merkmale umfaßt:
- ein UND-NICHT Tor (65), dessen Ausgang mit dem D-Eingang eines ersten (81) und eines zweiten (82) D-Flip-Flops verbunden ist, deren Takteingänge jeweils den Übertragungsbefehl (TO) empfangen
- ein drittes D-Flip-Flop (83), das direkt das Ausgangssignal des zweiten Flip-Flops empfängt und dessen Takteingang das Ausgangssignal (Q2) der p-ten Zelle (53) unter den p ersten Zellen (51, 52 53) empfängt,
- ein ODER-Tor (84), dessen erster Eingang das invertierte Ausgangssignal des ersten D-Flip-Flops (81) empfängt und dessen zweiter Eingang direkt das Ausgangssignal des dritten D-Flip-Flops (83) empfängt, wobei der Ausgang dieses ODER-Tores den Übertragungsimpuls (T1) für die n-p Zellen höheren Ranges liefert, und
- eine Rücksetzschalteung (85, 86, 87), um das zweite und dritte Flip-Flop auf Null zurückzusetzen und um das erste Flip-Flop kurz nach der Abgabe des Übertragungsimpulses (T1) auf Eins zu setzen.

5. Zähler nach einem der Ansprüche 1 bis 4, dadurch gekennzeichnet, daß p = 3 und n = 24.

6. Zähler nach Anspruch 5, dadurch gekennzeichnet, daß die Taktfrequenz (f) der p ersten Zellen 30 MHz ist.
